(19) Europäisches Patentamt
European Patent Office
Office européen des brevets

(11) EP 1 058 964 B1

(12) EUROPÄISCHE PATENTSCHRIFT

(45) Veröffentlichungstag und Bekanntmachung des Hinweises auf die Patenterteilung:
**12.06.2002 Patentblatt 2002/24**

(21) Anmeldenummer: **99917761.1**

(22) Anmeldetag: **02.03.1999**

(51) Int Cl.[7]: **H03H 7/01**

(86) Internationale Anmeldenummer:
**PCT/DE99/00550**

(87) Internationale Veröffentlichungsnummer:
**WO 99/45643 (10.09.1999 Gazette 1999/36)**

# (54) TIEFPASSFILTER FÜR EINE FREQUENZWEICHE

LOW-PASS FILTER FOR A DIPLEXER

FILTRE PASSE-BAS POUR DIPLEXEUR

(84) Benannte Vertragsstaaten:
**DE ES FR GB IT**

(30) Priorität: **03.03.1998 DE 19809021**

(43) Veröffentlichungstag der Anmeldung:
**13.12.2000 Patentblatt 2000/50**

(73) Patentinhaber: **Vacuumschmelze GmbH
63450 Hanau (DE)**

(72) Erfinder:
- **PETZOLD, Jörg
D-63486 Bruchköbel (DE)**
- **BEICHLER, Johannes
D-63110 Rodgau (DE)**
- **HEUMANN, Dirk
D-61130 Nidderau (DE)**

(74) Vertreter: **Patentanwälte
Westphal, Mussgnug & Partner
Waldstrasse 33
78048 Villingen-Schwenningen (DE)**

(56) Entgegenhaltungen:
**EP-A- 0 505 595**
**EP-A- 0 677 938**
**EP-A- 0 780 854**
**US-A- 5 567 537**

- **Fachkunde Elektrotechnik, S.85, 448,449, Verlag EUROPA Lehrmittel,DE, 1984**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft ein Tiefpaßfilter für eine Frequenzweiche zur Trennung von niederfrequenten Signalen analoger Kommunikationssysteme von hochfrequenten Signale digitaler Kommunikationssysteme mit einer Vielzahl von in Reihe geschalteten, mit Hilfe von Magnetkernen gebildeten Längsinduktivitäten.

Als Magnetkerne wurden bisher RM4, RM6, RM8 sowie andere Ferritschalenkerne aus Kernwerkstoffen, wie beispielsweise N27 und N48, eingesetzt. Die erforderliche Gleichfeldvorbelastbarkeit und die notwendige Linearität der Hystereseschleife wurde dabei mittels Scherung durch Schlitzen des Ferritkerns erreicht.

Ein Nachteil der Scherung ist, daß sie einen Rückgang der effektiv wirksamen Kernpermeabilität bis auf Werte um 200 bewirkt. Zum Erreichen der erforderlichen Hauptinduktivität muß deshalb beim Ferritkern das Volumen sehr groß ausgelegt werden, so daß ein aus Ferritkernen hergestelltes Tiefpaßfilter einen hohen Platzbedarf aufweist. Ein weiterer Nachteil der Ferritkerne sind die hohen Windungszahlen von primär- und sekundärseitigen Bewicklungen, die zu ohmschen Verlusten und kapazitiv bedingten Störeffekten führen können.

In EP 0 677 938 wird eine Frequenzweiche beschrieben, die einen Tiefpaßfilter und einen Hochpaßfilter umfaßt. Der Tiefpaßfilter weist in Reihe geschaltete, mit Hilfe von ferromagnetischen Magnetkernen gebildete Längsinduktivitäten auf.

In EP 0 780 854 wird eine stromkompensierte Funkentstördrossel beschrieben, die einen Magnetkern auf einer nanokristallinen Legierung aufweist. Der Magnetkern weist eine Permeabilität im Bereich von 10.000 bis 60.000, eine Sättigungsinduktion von größer als 1 Tesla und einen spezifischen Widerstand von größer als 90 $\mu\Omega$ cm auf. Aufgrund der hohen Permeabilität und der hohen Sättigungsinduktion weist die stromkompensierte Funkentstördrossel eine besonders kleine Bauform auf. Die Eigenschaften der nanokristallinen Legierung sind derart, daß trotz einer kleinen Bauform der Funkentstördrossel eine gute Entstörwirkung erzielt wird.

Ausgehend von diesem Stand der Technik liegt der Erfindung die Aufgabe zugrunde, ein Tiefpaßfilter mit geringem Bauvolumen zu schaffen, das die für den Einsatz in einer Frequenzweiche bestehenden Anforderungen hinsichtlich der Gleichfeldvorbelastbarkeit und der Filtergüte erfüllt.

Diese Aufgabe wird erfindungsgemäß durch die Merkmale im kennzeichneden Teil von Anspruch wodurch gelöst, die Oberwellen der niederfrequenten Signale durch die mit zunehmender Frequenz wachsende Impedanz der Längsinduktivitäten unterdrückbar sind.

Mit amorphen und nanokristallinen Legierungen lassen sich Magnetkerne mit einer hohen Sättigungsinduktion und einem breiten Bereich von Permeabilitätswerten herstellen. Magnetkerne aus einer amorphen oder nanokristallinen Legierung weisen daher im Vergleich zu herkömmlichen Ferritkernen bei vergleichbaren magnetischen Eigenschaften ein wesentlich kleineres Bauvolumen auf. Es ist jedoch schwierig, Magnetkerne aus amorphen oder nanokristallinen Legierungen so herzustellen, daß die Hystereseschleife, die für den Einsatz in Breitbandkommunikationssystemen erforderliche Linearität aufweist. Ein hohes Maß an Linearität ist aber erforderlich, um die Konstanz der Permeabilität und damit der Induktivität der Tiefpaßfilterdrosseln zu gewährleisten. Anderenfalls wird die Dimensionierung der Tiefpaßfilterdrosseln wesentlich erschwert. Nun ist es aber im allgemeinen erforderlich, mehrere Induktivitäten in Reihe zu schalten, um die erforderliche Filtergüte zu erzielen. Durch die Reihenschaltung der Längsinduktivitäten verstärken sich die auf Nichtlinearitäten der Hystereseschleife zurückgehenden Störungen. Die durch Nichtlinearitäten der Hystereseschleifen hervorgerufenen Oberwellen werden jedoch durch die mit zunehmender Frequenz ansteigende Impedanz der Längsinduktivitäten gedämpft. Es ist also möglich, trotz der mangelhaften Linearität der Hystereseschleifen der verwendeten Magnetkerne aus einer amorphen oder nanokristallinen Legierung ein Tiefpaßfilter zu bauen, das den Anforderungen an die Linearität der Übertragungskennlinie genügt. Wegen der im Vergleich zu Ferriten höheren Sättigungsinduktion und Permeabilität der nanokristallinen und amorphen Materialien ergeben sich darüber hinaus für die Magnetkerne kleinere Bauformen.

Für die Verwendung in Tiefpaßfiltern bevorzugte Legierungen sind Gegenstand der abhängigen Ansprüche.

Im folgenden wird die Erfindung im einzelnen anhand der beigefügten Zeichnung beschrieben. Es zeigen:

Figur 1 eine Übersicht über die Verbindung zwischen einer Ortsvermittlungsstelle und einem teilnehmerseitigen Netzabschluß;

Figur 2 eine einen Hochpaß und einen Tiefpaß aufweisende Frequenzweiche;

Figur 3 eine ein hohes Maß an Linearität aufweisende Hystereseschleife;

Figur 4 ein Diagramm, das die Abhängigkeit der Permeabilität von der Überlagerungsfeldstärke darstellt;

Figur 5 den Frequenzgang des Realteils und des Imaginärteils der Permeabilität von Tiefpaßfilterdrosseln;

Figur 6 den Frequenzgang des Betrages der Impedanz der Tiefpaßfilterdrosseln aus Figur 5; und

Figur 7 den gemessenen Frequenzgang des Imaginärteils der Permeabilität eines Magnetkerns mit großer Oberflächenrauhigkeit.

Da VDSL-Splitter noch nicht in allen Details festgelegt sind, werden im folgenden vor allem Baulemente des ADSL-Systems beschrieben. Nach heutigem Kenntnisstand ist davon auszugehen, daß die Anforderungen an die induktiven Bauelemente für das VDSL-Tiefpaß-System denen des ADSL-Tiefpaß-Systems weitgehend entsprechen.

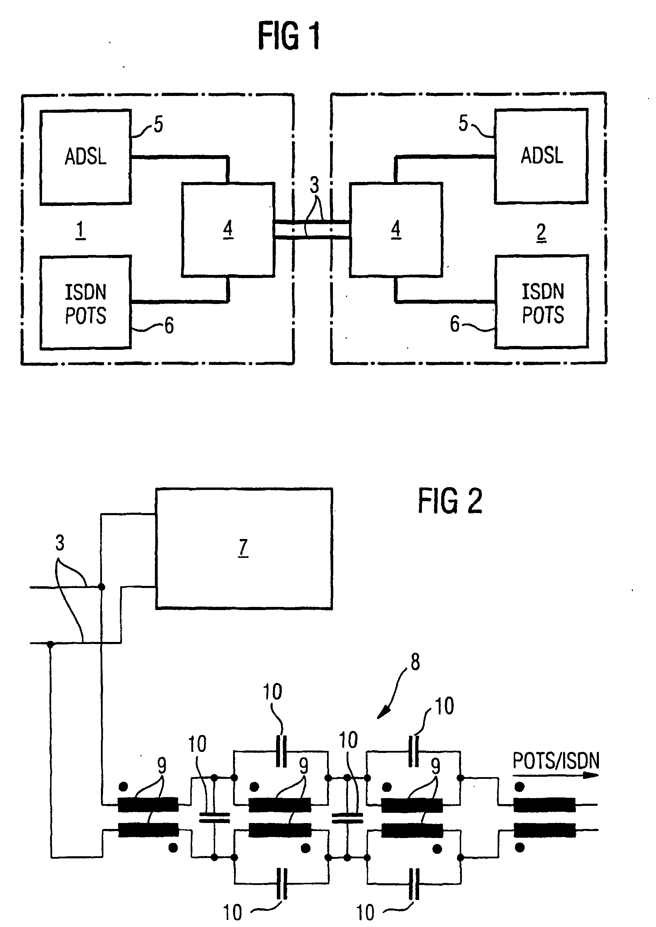

Wie in Figur 1 dargestellt, erfolgt im ADSL(Asymmetric Digital Subscriber Line)-Telekommunikationssystem die Verbindung zwischen einer ADSL-fähigen digitalen Ortsvermittiungsstelle 1 und einem ADSL-Modem 2, dem teilnehmerseitigen Netzabschluß, über eine öffentliche Zweidrahtleitung 3. Zeitgleich können über die Zweidrahtleitung 3 POTS(plain old telephone system)- oder ISDN(Integrated Services Digital Network)-Verbindungen laufen. Die Trennung und Übertragung der niederfrequenten (POTS, ISDN) und der hochfrequenten Komponenten (ADSL) wird durch Frequenzweichen 4 (POTS-, ISDN-Splitter) bewirkt, die an den Enden der öffentlichen Zweidrahtleitung 3 sitzen. Die über die öffentliche Zweidrahtleitung 3 laufenden hochfrequenten ADSL-Signale werden von den Frequenzweichen 4 in einen ADSL-Zweig 5 gelenkt, während die niederfrequenten POTS- und ISDN-Signale von den Frequenzweichen 4 jeweils in einem POTS-/ISDN-Zweig 6 gelenkt werden.
Die Frequenzweiche 4 umfaßt demzufolge ein Hochpaßfilter 7 und ein Tiefpaßfilter 8, das aus Tiefpaßfilterdrosseln 9 und Kondensatoren 10 gebildet ist.

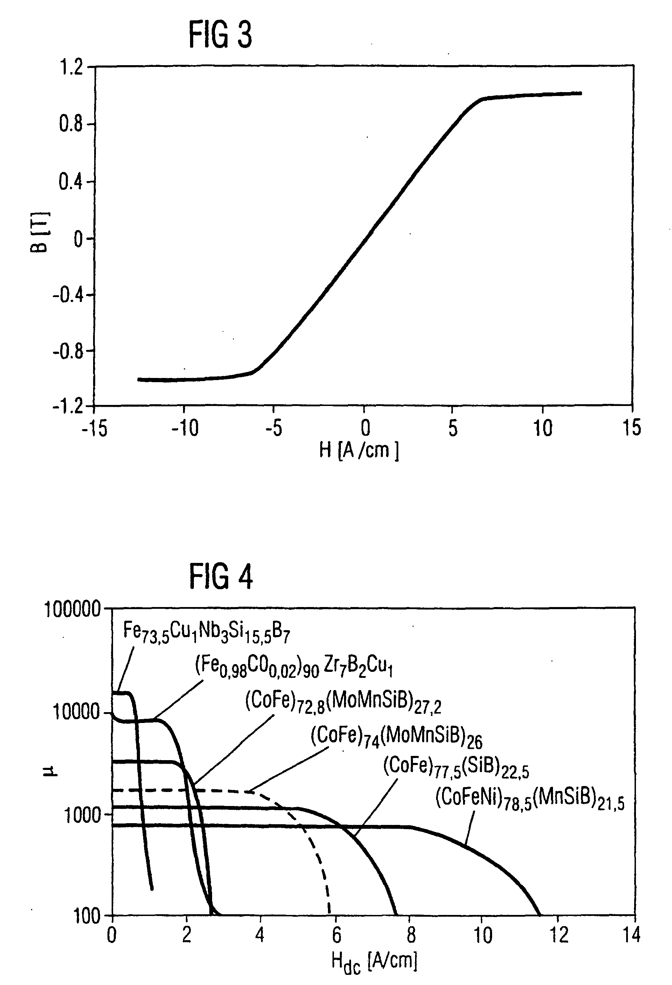

Anzumerken ist, daß unterschiedliche Ausführungsformen für das Tiefpaßfilter 8 möglich sind. So kann das Tiefpaßfilter 8, wie in Figur 2, ausschließlich aus passiven Komponenten bestehen oder auch zusätzlich aktive Komponenten enthalten. Die hier vorgestellten Tiefpaßfilterdrosseln 9 sind jedoch unabhängig von der jeweiligen Ausführungsform des Tiefpaßfilters 8 einsetzbar.

Je nach dem Übertragungssystem unterscheidet man das DMT-System (discrete multitone) und das CAP-System (carrierless amplitude phase modulation). Die Codierungen wirken sich insbesondere auf die spektrale Verteilung des Magnetisierungsstromes des Hochpaß-Zweigs 5 der Frequenzweiche 4 aus.

Die maximale Amplitude im ADSL-System kann bis $U_{ac}$=30 $V_{pp}$ betragen, im POTS-System bis $U_{ac}$ = 15 $V_{pp}$. Durch den POTS-Zweig fließt ein Gleichstrom $I_{dc}$(POTS) < 100 mA, durch den ISDN-Zweig ein Gleichstrom $I_{dc}$(ISDN) < 80 mA. Bei POTS-Systemen kommt ein maximaler Klingelstrom $I_{ac}$ hinzu, dessen Höhe und Frequenz von der Auslegung des Klingelgenerators abhängt.

Diese Ströme führen zu einer Gleichstromvorbelastung der Tiefpaßfilterdrosseln 9, deren Höhe entscheidend durch die Ausführungsform der Tiefpaßfilterdrossel 9 und den für die Magnetkerne verwendeten Werkstoffe bestimmt wird.

Durch $I_{dc}$(ISDN) oder $I_{dc}$(POTS) und $I_{ac}$(POTS), verknüpft mit der $U_{ac}$-Aussteuerung, darf das Tiefpaßfilter 8 weder in Sättigung gehen noch so weit ausgesteuert werden, daß systemspezifische Eigenschaften, die in den einschlägigen Normen festgelegt sind, nicht mehr erfüllt werden.

An die auf beiden Seiten der öffentlichen Zweidrahtleitung 3 eingesetzten Induktivitäten sind die folgenden Anforderungen gestellt:

a) minimales Bauvolumen
b) Eignung für die Übertragungscodesysteme

- DMT
- CAP
- QAM / MQAM ((Multiple) Quadrature Amplitude Modulation)

c) Hauptinduktivitäten < 100 mH je nach Filterauslegung
d) Gleichstromüberlagerung bei Fernspeisung

- 0 - 100 mA bei POTS + $I_{ac}$, abhängig von der Auslegung des Klingelgenerators
- 0 - 80 mA bei ISDN

e) Loops nach ANSI T1.413 und ETSI ETR 328
f) geringes Kerngewicht und SMD-Fähigkeit
g) Ringkernform, dadurch einfachere Sicherheitsanforderungen nach IEC 950.

Diese Anforderungen lassen sich durch kleine ungeschlitzte Ringbandkerne erfüllen, die aus einer amorphen, nahezu magnetostriktionsfreien Kobalt-Basis-Legierungen oder aus einer praktisch magnetostriktionsfreien feinkristallinen Legierung hergestellt sind.

Letztere werden üblicherweise als "nanokristalline Legierungen" bezeichnet und sind durch ein extrem feines Korn mit einem mittleren Durchmesser von weniger als 100 nm gekennzeichnet, das mehr als 50 % des Materialvolumens einnimmt. Eine wichtige Voraussetzung ist, daß die Induktivitäten eine hohe Sättigungsinduktion von $B_s > 0,6$ T, vorzugsweise > 0,9 T, und eine sehr lineare Hystereseschleife mit einem Sättigungs- zu Remanenzverhältnis $B_r/B_s < 0,2$ , vorzugsweise < 0,08 besitzen. Außerdem muß die Permeabilität bei POTS-Splittern bis oberhalb von 10 kHz, bei ISDN-Splittern bis weit oberhalb von 100 kHz weitestgehend konstant bleiben. Darüber hinaus wurde herausgefunden, daß sich Tiefpaßfilterdrosseln 9 für POTS - Splitter auch aus einigen amorphen Eisen-Basis-Legierungen herstellen lassen. In beiden Fällen sind die weit über 1 Tesla liegenden Werte der Sättigungsinduktion von großem Vorteil. Eine Aufzählung sämtlicher betrachteter und für die Verwendung in Frequenzweichen als geeignet befundener Legierungssysteme findet sich weiter unten.

Die grundsätzliche Voraussetzung für das Erreichen der für POTS-Splitter, vor allem aber für ISDN-Splitter geforderten Eigenschaften ist ein ausgeprägtes Linearitätsverhalten der Hystereseschleifen, wie dies beispielsweise in Figur 3 dargestellt ist. Solche linearen Hystereseschleifen können zum Beispiel durch die nachfolgend beschriebenen Fertigungsgänge erreicht werden:

Das mittels Rascherstarrungstechnologie hergestellte weichmagnetische amorphe Band der Dicke d < 30 µm, vorzugsweise < 23 µm aus einer der unten aufgezählten Legierungen wird auf speziellen Maschinen spannungsfrei zum Ringbandkern in dessen Endabmessung gewickelt.

Bei der anschließenden Wärmebehandlung zur Einstellung der weichmagnetischen Eigenschaften ist zu unterscheiden, ob der Kern aus einer Legierung besteht, die sich zur Einstellung einer nanokristallinen Struktur eignet oder nicht.

Ringbandkerne aus Legierungen, die sich zur Nanokristallisation eignen, werden zur Einstellung des nanokristallinen Gefüges einer Kristallisationwärmebehandlung unterzogen, die je nach Legierungszusammensetzung zwischen 450 °C und 680 °C liegt. Typische Haltezeiten liegen zwischen 4 Minuten und 8 Stunden. Je nach Legierung ist diese Kristallisationwärmebehandlung im Vakuum oder im passiven oder reduzierenden Schutzgas durchzuführen. In allen Fällen sind materialspezifische Reinheitsbedingungen zu berücksichtigen, die fallweise durch entsprechende Hilfsmittel wie elementspezifische Absorber- oder Gettermaterialien herbeizuführen sind. Dabei wird durch eine genau abgeglichene Temperatur- und Zeitkombination ausgenutzt, daß sich bei den weiter unten angegebenen Legierungssystemen gerade die Magnetostriktionsbeträge von feinkristallinem Korn und amorpher Restphase ausgleichen und die erforderliche Magnetostriktionsfreiheit ($|\lambda_s| < 2$ ppm, vorzugsweise sogar $|\lambda_s| < 0,2$ ppm) entsteht. Je nach Legierung und Ausführungsform der Tiefpaßfilterdrossel 9 wird entweder feldfrei oder im Magnetfeld längs zur Richtung des gewickelten Bandes ("Längsfeld") oder quer dazu ("Querfeld") getempert. In bestimmten Fällen kann auch eine Kombination aus zwei oder sogar drei dieser Magnetfeldkonstellationen nötig werden. Besonders flache und lineare Schleifen lassen sich dann erreichen, wenn die Ringbandkerne stirnseitig exakt so aufgestapelt sind, daß die Stapelhöhe mindestens das 10-fache, vorzugsweise wenigstens das 20-fache des Kernaußendurchmessers beträgt, und wenn bereits während der beschriebenen Kristallisationswärmebehandlung ein starkes Querfeld anliegt. Die Hystereseschleife wird dabei umso flacher, je höher die Querfeldtemperatur angesetzt wird, wobei das Überschreiten der legierungsspezifischen Curietemperaturen sowie die Entstehung unmagnetischer Phasen eine obere Grenztemperatur festlegt.

Die magnetischen Eigenschaften, das heißt die Linearität und die Steigung der Hystereseschleife können -falls nötig - weiträumig durch eine zusätzliche Wärmebehandlung in einem Magnetfeld, das parallel zur Rotationssymmetrieachse des Ringbandkerns - also senkrecht zur Bandrichtung steht, variiert werden. Je nach Legierung und einzustellendem Permeabilitätsniveau sind dabei Temperaturen zwischen 350 °C und 680 °C erforderlich. Aufgrund der Kinetik der atomaren Reorientierungsvorgänge sind die resultierenden Permeabilitätswerte umso niedriger, je höher die Querfeldtemperatur ist. Typische Kennlinien verschiedener erfindungsgemäß eingesetzter nanokristalliner Magnetlegierungen sind der Figur 4 zu entnehmen. Diese Magnetfeld-Wärmebehandlung kann entweder direkt mit der Kristallisationsglühung kombiniert oder separat durchgeführt werden. Für die Glühatmosphäre gelten dieselben Bedingungen wie bei der Glühung zur Einstellung der nanokristallinen Struktur.

Bei Ringbandkernen aus amorphen Werkstoffen erfolgt die Einstellung der magnetischen Eigenschaften, das heißt von Verlauf und Steigung der linearen flachen Hystereseschleife durch eine Wärmebehandlung in einem Magnetfeld, das parallel zur Rotationssymmetrieachse des Ringbandkerns - also senkrecht zur Bandrichtung verläuft. Durch eine günstige Führung der Wärmebehandlung wird ausgenutzt, daß sich der Wert der Sättigungsmagnetostriktion während der Wärmebehandlung um einen von der Legierungszusammensetzung abhängigen Betrag in positive Richtung verändert, bis er in den Bereich $|\lambda_s| < 2$ ppm, vorzugsweise sogar $|\lambda_s| < 0,1$ ppm trifft. Wie Tabelle 2 zeigt, ist dies auch dann erreichbar, wenn der Betrag von $\lambda_s$, im as quenched Zustand des Bandes deutlich über diesem Wert liegt. Wichtig dabei ist je nach eingesetzter Legierung eine Bespülung des Ringbandkerns entweder mit Luft oder einem reduzierenden (z.B. $NH_3$, $H_2$, CO) oder passiven Schutzgas (z.B. He, Ne, Ar, $N_2$, $CO_2$), so daß an den Bandoberflächen weder Oxidation noch andere Reaktionen auftreten können. Genausowenig dürfen im Innern des Materials festkörperphysikalische Reaktionen durch eindiffundierendes Schutzgas ablaufen.

Typischerweise werden die Ringbandkerne für das Tiefpaßfilter 8 je nach eingesetzter Legierungszusammensetzung unter angelegtem Magnetfeld mit einer Rate von 0,1 bis 10 K/min auf Temperaturen zwischen 220 °C und 420 °C aufgeheizt, zwischen 0,5 und 48 Stunden im Magnetfeld in diesem Temperaturbereich gehalten und anschließend mit 0,1 - 5 K/min wieder auf Raumtemperatur abgekühlt. Aufgrund der Temperaturabhängigkeit der magnetischen Momente sind die resultierenden Schleifen bei den erfindungsgemäß eingesetzten Amorphlegierungen umso flacher und linearer, je niedriger die Querfeldtemperaturen sind. Besonders flache und lineare Schleifen lassen sich dann erreichen, wenn die Ringbandkerne stirnseitig exakt so aufgestapelt sind, daß die Stapelhöhe mindestens das 10-fache, besser wenigstens das 20-fache des Kernaußendurchmessers beträgt. Typische Kennlinien sind der Figur 4 zu entnehmen.

Fallweise kann auch auf ein Temperaturplateau im Querfeld verzichtet werden und die magnetische Vorzugsrichtung durch Abkühlen der Ringbandkerne im Querfeld erzeugt werden. Das Permeabilitätsniveau wird dann über die Abkühlrate unterhalb der Curietemperatur des Magnetwerkstoffes eingestellt.

Im Anschluß an die Wärmebehandlung werden die Ringbandkerne oberflächlich passiviert, beschichtet, wirbelgesintert oder in einem Trog verkapselt, mit den Wicklungen versehen und falls erforderlich im Bauelementgehäuse verklebt oder vergossen. Dieses Verfahren ist unabhängig davon, ob der Ringbandkern aus amorphem oder nanokristallinem Material besteht. Aufgrund der Sprödigkeit hat allerdings die mechanische Handhabung der ausgetemperten nanokristallinen Ringbandkerne mit besonderer Vorsicht zu erfolgen.

Eine weitere Fertigungsmöglichkeit ist, daß das Band zunächst einer Querfeldtemperung im Durchlauf unterzogen und anschließend zum Ringbandkern gewickelt wird. Der weitere Ablauf verläuft wie oben beschrieben.

Die mit diesem Verfahren hergestellten Ringbandkerne erfüllen dann folgende Anforderungen:

Die Hauptinduktivität des bewickelten Ringbandkerns liegt je nach Auslegung der Tiefpaßfilterdrossel 9 im Bereich von 1 bis 100 mH, bei besonderen Ausführungsformen der Tiefpaßfilter 8 (z.B. elliptische Charakterisitik) ist die Hauptinduktivität auch < 1mH.

Weiterhin erfüllt die Hauptinduktivität diesen Wert auch unter einer Gleichstromüberlagerung und maximaler Wechselaussteuerung sowie den normmäßig festgelegten Frequenzen.

Der Linearitätsfehler der Hystereseschleife des Ringbandkerns ist dabei so gering, daß gilt:

$$\mu(4/5{*}B_s)/\mu(1/100{*}B_s) > 0{,}7, \text{ vorzugsweise } > 0{,}9.$$

Die in typischen Anwenderschaltungen erzielbaren Bitfehlerrten sind konform mit den Normen (FTZ 1TR220 und ETSI ETR 80).

Insbesondere bei Verwendung einer amorphen Legierung der Zusammensetzung $Co_{55,6}Fe_{6,1}Mn_{1,1}Si_{4,3}B_{16,2}Ni_{16,2}$ ergeben sich nach abgeglichener Querfeldtemperung bei 280 - 360 °C für vorgegebene Werte von Hauptinduktivität und Gleichstrombelastbarkeit die in Tab. 1 dargestellten typischen minimalen Kernabmessungen.

Tab. 1

| $L_{haupt}$ [rnH] | $I_{dc,max}$ [mA] | Kernabmessung [mm$^3$] | Kernmasse [g] |
|---|---|---|---|
| 6,2 | 100 | 9,2 x 6,5 x 4,5 | 0,96 |
| 7,9 | 100 | 9,8 x 6,5 x 4,5 | 1,22 |
| 9,2 | 100 | 9,8 x 6,5 x 4,5 | 1,22 |
| 12,1 | 100 | 11,3 x 8,0 x 5,5 | 1,81 |
| 16,9 | 100 | 12,3 x 8,0 x 5,5 | 2,48 |
| 27,6 | 100 | 14,3 x 8,0 x 5,5 | 4,00 |

Ähnliche Kernabmessungen ergeben sich auch beim Einsatz der anderen unten aufgezählten Legierungen, die anwendungsspezifisch eingesetzt werden.

Bei der Dimensionierung der Tiefpaßfilterdrosseln 9, sind eine Reihe von Zusammenhängen zu beachten.

Für die Induktivität des Übertragers gilt der Zusammenhang

$$L = N^2 \mu_o \mu_r A_{fe}/L_{fe} \qquad (1)$$

N = Windungszahl
$\mu_o$ = universelle Permeabilitätskonstante
$\mu_r$ = Permeabilität des Materials
$A_{fe}$ = Eisenquerschnitt des Ringbandkerns
$L_{fe}$ = Eisenweglänge des Ringbandkerns.

Aus Gleichung (1) wird ersichtlich, daß die erforderliche Induktivität bei minimalem Bauvolumen nur dann erreichbar ist, wenn Windungszahlen, Permeabilität, Kernquerschnitt und Eisenweglänge aufeinander abgestimmt sind. Die Permeabilität des Kernmaterials ist neben der günstigen ringförmigen Geometrie der ausschlaggebende Parameter für eine möglichst kompakte Abmessung der Tiefpaßfilterdrossel 9. Je nachdem welche der nachfolgend aufgezählten Legierungen zum Einsatz kommt, und wie die zugehörige Wärmebehandlung geführt wird, läßt sich in definierter Weise ein Permeabilitätsbereich zwischen 500 und 120.000 abdecken. Bei den für die Verwendung in ADSL-Systemen geeigneten Tiefpaßfilterdrosseln 9 kommt vorzugsweise der Permeabilitätsbereich unter 20.000 zum Einsatz, was hinsichtlich der Dimensionierung der Induktivitäten einen hohen Grad an Flexibilität bringt. Die mit diesen Ringbandkernen gebauten Tiefpaßfilter 8 besitzen gegenüber den geschlitzten Ferritkernen ($\mu_r$ = 100 - 400) einen starken Volumenvorteil, sowie aufgrund der geringeren Windungszahlen der Bewicklung große elektrotechnische Vorteile.

Bei der Auswahl des Kernwerkstoffes für die Induktivitäten des Tiefpaßfilters 8 entsteht eine grundsätzliche Einschränkung dadurch, daß die Induktivität durch $I_{dc}$(ISDN) oder $I_{dc}$(POTS) und $I_{ac}$(POTS) nicht bis in Sättigungsnähe aufmagnetisiert werden darf.

Die der Signalaussteuerung überlagerten Gleichströme führen zu einer Gleichfeldvorbelastung

$$H_{dc} = I_{dc}N/L_{fe} \qquad (2)$$

unter der die Permeabilität nur sehr geringfügig abfallen darf. Aus diesem Grunde erfolgt die Beurteilung des Materials anhand von $\mu(H_{dc})$ -Kennlinien wie sie in Figur 4 beispielhaft für verschiedene für die Tiefpaßfilterdrosseln 9 entwickelte amorphe und nanokristalline Werkstoff-Kernkombinationen dargestellt sind.

Da nach Figur 4 der ausnutzbare konstante Arbeitsbereich der $\mu(H_{dc})$-Kennlinie von der Größe der Anisotropiefeldstärke

$$H_a = B_s / (\mu_o{}^* \mu_r) \qquad (4)$$

abhängt, muß die Legierungszusammensetzung in Kombination mit der Querfeldwärmebehandlung so festgelegt sein, daß einerseits die Sättigungsinduktion möglichst hoch, andererseits die Permeabilität möglichst niedrig ist. Da aber nach Gleichung 1 eine besonders niedrige Permeabilität mit einer Vergrößerung der Windungszahl N ausgeglichen werden muß, wodurch die in Gleichung 2 definierte Gleichfeldvorbelastung $H_{dc}$ wiederum steigt, ist bei Legierungsauswahl und Wärmebehandlung für Tiefpaßinduktivitäten ein Kompromiß aus hoher Anisotropiefeldstärke und hinreichend hoher Permeabilität zu finden.

Bei der Dimensionierung der Tiefpaßfilterdrosseln 9 ist weiterhin darauf zu achten, daß der Betrag der Impedanz der Tiefpaßfilterdrossel 9 mit zunehmender Frequenz ansteigt, denn dadurch werden von Nichtlinearitäten in der Hystereseschleife des Ringbandkerns erzeugte Oberwellen auf wirksame Weise unterdrückt.

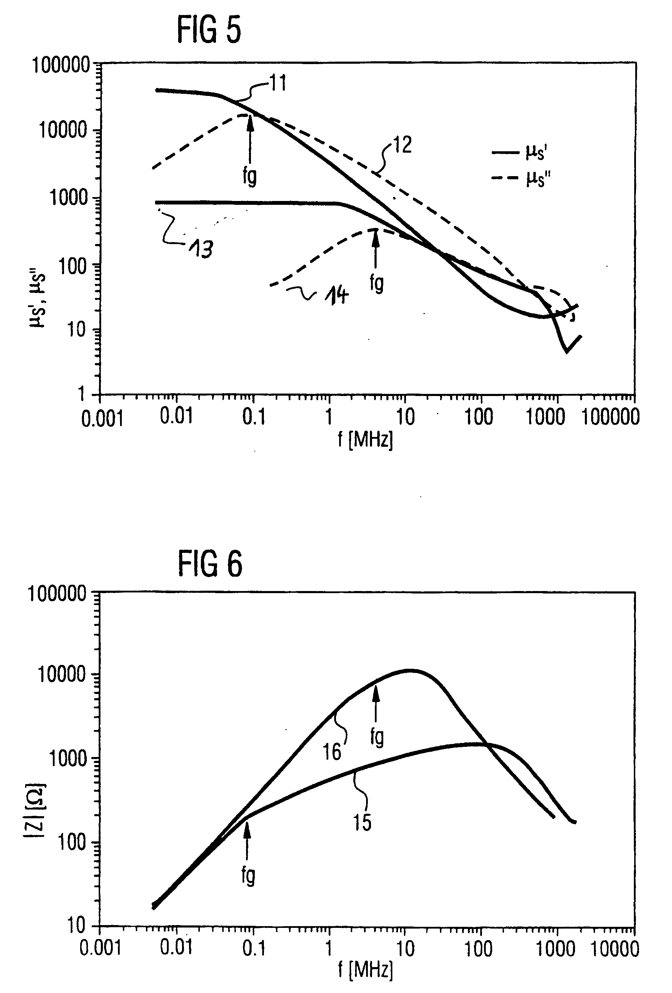

Dies wird nachfolgend anhand der Figuren 5 bis 7 näher erläutert.

Im seriellen Ersatzschaltbild wird die Tiefpaßfilterdrossel 9 durch einen in Reihe geschalteten Ohmschen Widerstand und eine ideale Induktivität dargestellt. Die Größe des Ohmschen Widerstands wird vom Imaginärteil der Permeabilität bestimmt. Der Realteil der Permeabilität dagegen legt die Größe der idealen Induktivität fest.

Figur 5 zeigt die typische Abhängigkeit des Realteils $\mu_s'$ und des Imaginärteils $\mu_s''$ von der Frequenz f. Dargestellt ist der Verlauf für zwei Ausführungsbeispiele mit unterschiedlicher Anfangspermeabilität. Die Kurve 11 stellt den Verlauf des Realteils $\mu_s'$ eines Ausführungsbeispiels mit einer Anfangspermeabilität von 37000 dar. Die gestrichene Kurve 12 deutet den Verlauf des Imaginärteils $\mu_s''$ dieses Ausführungsbeispiels an. Entsprechendes gilt für die durchgezogene Kurve 13 und die gestrichelte Linie 14, die jeweils den Realteil $\mu_s'$ und den Imaginärteil $\mu_s''$ eines Ausführungsbeispiels mit einer Anfangspermeabilität von 800 darstellen.

Anhand Figur 5 ist erkennbar, daß die Imaginärteile $\mu_s''$ der Permeabilität ein Maximum bei einer Wirbelstromgrenzfrequenz $f_g$ aufweisen. Im Bereich der gleichen Frequenz beginnt der Realteil $\mu_s'$ der Permeablität abzufallen.

In Figur 6 ist der sich daraus ergebende Verlauf des Betrags der Impedanz Z dargestellt. Die beiden Ausführungsformen sind so ausgelegt, daß sie zumindest bei niedrigen Frequenzen die gleiche Induktivität aufweisen. Dementsprechend ist der Ringbandkern mit einer Anfangspermeabilität von 800 mit 48 Windungen umwickelt, während der Ringbandkern mit einer Anfangpermeabilität von 37000 mit 8 Windungen umwickelt ist. Da beide Tiefpaßfilterdrosseln 9 bei niedrigen Frequenzen die gleiche Induktivität aufweisen, weicht eine für das Ausführungsbeispiel mit der hohen Anfangspermeabilität kennzeichnende Kurve 15 für niedrige Frequenzen nur wenig von einer für das Ausführungsbeispiel mit niedriper Anfangspermeablität kennzeichnenden Kurve 16 ab. Bei der Wirbelstromgrenzfrequenz $f_g$ jedoch beginnt die Kurve 15 abzuflachen, um schließlich bedingt durch die Kapazität der Wicklung oberhalb eines Maximums abzufallen. Gleiches gilt für die Kurve 16. Bei Annäherung an die Grenzfrequenz $f_g$ beginnt die Kurve 16 etwas abzuflachen, um schließlich jenseits eines Maximums bedingt durch die große Kapazität der von 48 Windungen gebildeten Wicklung abzufallen.

Der Frequenzgang der Impendanz hat auch Auswirkungen auf die Filtergüte des Tiefpaßfilters 8, denn die von Nichtlinearitäten der Hystereseschleife verursachten Oberwellen des niederfrequenten Signals kann man sich von einer Störspannungsquelle erzeugt denken, die an einen Abschlußwiderstand angeschlossen ist, an dem das Ausgangssignal abgegriffen wird. Der Innenwiderstand der Störspannungsquelle ist dann bestimmt durch die Impedanz der Tiefpaßfilterdrossel 9. Da bei hohen Frequenzen die Impendanz der Tiefpaßfilterdrossel 9 stark ansteigt, fällt die von der Störspannungsquelle erzeugte Störspannung hauptsächlich am Innenwiderstand der Störspannungsquelle und nicht am Abschlußwiderstand ab. Auf diese Weise werden die durch Nichtlinearitäten der Hystereseschleife hervorgerufenen Oberwellen des niederfrequenten Signals auf wirksame Weise unterdrückt. Dies setzt allerdings einen ausreichend starken Impedanzanstieg bei hohen Frequenzen voraus. Der Anstieg der Impedanz sollte wenigstens bis zur fünften Oberwelle, vorzugsweise bis zur elften Oberwelle erfolgen. Anhand Figur 6 wird deutlich, daß es in diesem Zusammenhang grundsätzlich von Vorteil ist, wenn die Anfangspermeabilitäten niedrig gewählt sind, so daß aufgrund der hohen Wirbelstromgrenzfrequenz die Impedanz auch bei hohen Frequenzen stark ansteigt. Im Vergleich zu Ausführungsbeispielen, bei denen die Anfangspermeabilität hoch gewählt ist, weist dies den zusätzlichen Vorteil auf, daß der Ringbandkern wegen der niedrigen Permeabilität nur wenig ausgesteuert wird. Da in diesem Fall nur ein geringer Teil des Hystereseschleife abgefahren wird, fallen bei großer Aussteuerung des Ringbandkerns auftretende Nichtlinearitäten weniger ins Gewicht.

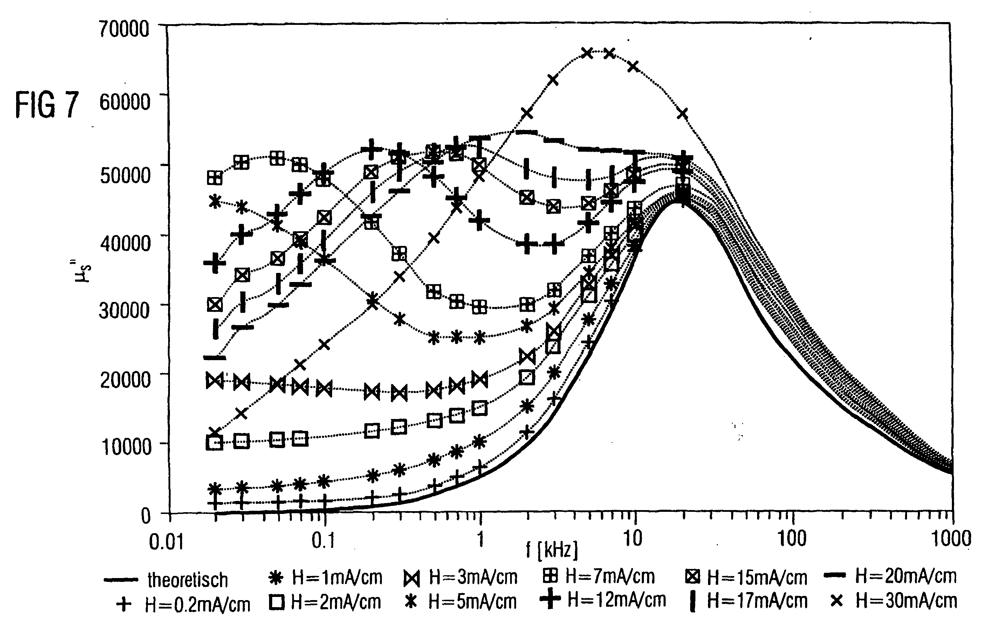

Es sei angemerkt, daß die in Figuren 5 und 6 dargestellten Verhältnisse nur dann gelten, wenn neben der Erzeugung von Wirbelströmen weitere dissipative Effekte zu vernachlässigen sind. Wenn beispielsweise bei der Fertigung der Ringbandkerne die Wärmebehandlung bei mangelhafter Schutzgasbespülung abläuft, können auf der Oberfläche der magnetischen Bänder verspanndene $SiO_2$-Schichten aufwachsen, durch die die Domänenwände im magnetischen Band vermehrt werden. Durch die einhergehende Oberflächenrauhigkeit entstehen außerdem entlang der Bandoberfläche Unsymmetrien, die die Ausbildung der Domänenwände weiter fördern. Die Rauhigkeiten der Bandoberfläche stellen außderdem Keime für die Wandverschiebungsprozesse dar. Umgekehrt bilden sich durch die Oberflächenrauhigkeit entmagnetisierende Felder aus, die eine rasche Ummagnetisierung verhindern. Ferner induziert die Wanderung der Domänenwände starke Wirbelstöme, die der Verschiebung der Domänenwände entgegenwirken. Insgesamt stellt die Verschiebung der Dömänenwände im Wechselfeld einen weiteren dissipativen Prozeß dar, der bei Frequenzen weit unterhalb der Wirbelstromgrenzfrequenz zu einem weiteren Maximum des Imaginärteiles $\mu_s''$ der Permeabilität führen kann. In Figur 7 ist der Frequenzgang des Imaginärteils $\mu_s''$ der Permeabilität in Abhängigkeit von der Stärke des angelegten äußeren Magnetfelds dargestellt. Da die oben beschriebenen Effekte in Abhängigkeit von der Stärke des angelegten äußeren Magnetfelds verschieden stark ausgeprägt sind, hängt der Frequenzgang des Imaginärteils $\mu_s''$ der Permeabilität nicht nur von der Frequenz, sondern auch von der Stärke des angelegten äußeren Magnetfelds ab. Es ist deshalb wesentlich, die Ringbandkerne möglichst spannungsfrei zu wickeln und die Wärmebehandlung in einer strömenden Schutzgasatmosphere durchzuführen.

Mit dem nachfolgend beschriebenen Legierungssystem lassen sich unter Einhaltung der oben genannten Bedingungen Tiefpaßfilter mit besonders linearen Hystereseschleifen und kleinen Bauformen herstellen, die alle normgerechten Eigenschaften besitzen.

Legierungssystem 1:

Ein für das POTS-Tiefpaßfilter geeignetes Legierungssystem hat die Zusammensetzung $Fe_aM_bSi_xB_yR_z$, wobei M ein oder mehrere Elemente aus der Gruppe Co, Ni bezeichnet und R ein oder mehrere Elemente aus der Gruppe C, V, Nb, Mn, Ti, Cr, Mo, W bezeichnet und a+b+x+y+z = 100 % ist, mit

| | |
|---|---|
| Fe | a = 61 - 82 at % |
| Co / Ni | b = 0 - 20 at % |
| Si | x = 0,5 - 19 at % |
| B | y = 7 - 23 at % |
| R | z = 0 - 3 at % |

mit $70 < a + b < 86$, vorzugsweise $73 < a + b < 85$ at % und $14 < x+y+z < 30$at%.

Legierungen dieses Systems bleiben nach der Wärmebehandlung amorph, besitzen aber aufgrund ihrer relativ großen Sättigungsmagnetostriktion, die bei + 20 ppm liegen kann, nicht ganz so ausgeprägte Linearitätseigenschaften wie die nachfolgend beschriebenen Co-Basis-Legierungen. Sie sind deshalb vorwiegend für POTS-Tiefpaßfilter geeignet.

Legierungssystem 2:

Ein weiteres geeignets Legierungssystem weist die Zusammensetzung $Co_a(Fe_{1-c}Mn_c)_bNi_dM_eSi_xB_yC_z$ auf, wobei M ein oder mehrere Elemente aus der Gruppe Nb, Mo, Ta, Cr, W, Ge und / oder P bezeichnet und a+b+c+d+e+x+y+z = 100 ist, mit

| Co | a = 40 - 82 at% | vorzugsweise a>50at% |
|---|---|---|
| Mn/Fe | c = 0 - 1 | vorzugsweise c<0.5 |
| Fe+Mn | b = 3 - 10 at% | |

| Ni: | d = 0 - 30 at% | vorzugsweise d < 20 at% |
|---|---|---|
| M: | e = 0 - 5 at% | vorzugsweise e < 3 at% |
| Si: | x = 0 - 15 at% | vorzugsweise x > 1 at% |
| B | y = 8 - 26 at% | vorzugsweise 8 - 20 at% |
| C | z = 0 - 3 at% | |

$$15<e+x+y+z<30 \text{ (vorzugsweise } 18<e+x+y+z<25).$$

Legierungen dieses Systems bleiben nach der Wärmebehandlung amorph, erfüllen den Anspruch $|\lambda_s| < 0,1$ ppm besonders gut und sind wegen ihrer linearen Schleifenform und des extrem guten Frequenzverhaltens sowohl für ISDN- als auch für POTS-Tiefpaßfilter besonders gut geeignet.

Legierungssystem 3:

Ein drittes geeignetes Legierungssystem hat die Zusammensetzung $Fe_xCu_yM_zSi_vB_w$ ,wobei M ein Element aus der Gruppe Nb, W, Ta, Zr, Hf, Ti, Mo oder eine Kombination aus diesen bezeichnet und x + y + z + v + w = 100 % ist, mit:

| Fe | x = 100 % - y - z - v - w | |
|---|---|---|
| Cu | y = 0,5 - 2 at% | vorzugsweise 1 at % |
| M | z = 1 - 5 at % | vorzugsweise 2 - 3 at % |
| Si | v = 6,5 - 18 at % | vorzugsweise 14 - 17 at% |
| B | w = 5 - 14 at % | |

wobei v + w > 18 at %, vorzugsweise v + w = 22 - 24 at %

Legierungen dieses Systems sind wegen ihrer linearen Schleifenform und des sehr guten Frequenzverhaltens sowohl für ISDN- als auch für POTS-Tiefpaßfilter gut geeignet.

Legierungssystem 4:

Ein weiteres geeignetes Legierungssystem weist die Zusammensetzung $Fe_xZr_yNb_zB_vCu_w$ auf, wobei x + y + z + v + w = 100 at % ist, mit:

| Fe | x = 100 at % - y - z - v - w | vorzugsweise 83 ... 86 at % |
|---|---|---|
| Zr | y = 2 - 5 at % | vorzugsweise 3 - 4 at % |
| Nb | z = 2 - 5 at % | |
| B | v = 5 - 9 at % | |

(fortgesetzt)

| | | |
|---|---|---|
| Cu | w = 0,5 - 1,5 at % | vorzugsweise 1 at % |

wobei y + z > 5 at %, vorzugsweise 7 at %,
und y + z + v > 11, vorzugsweise 12 - 16 at %.

Legierungen dieses Systems sind wegen ihrer linearen Schleifenform und des sehr guten Frequenzverhaltens sowohl für ISDN- als auch für POTS-Tiefpaßfilter gut geeignet.

Legierungssystem 5:

Ein weiteres Legierungssystem verfügt über die Zusammensetzung $Fe_xM_yB_zCu_w$ ,wobei M ein Element aus der Gruppe Zr, Hf, Nb bezeichnet und x + y + z + w = 100 at % ist, mit:

| | | |
|---|---|---|
| Fe | x= 100 at%-y-z-w | vorzugsweise 83 - 90 at % |
| M | y = 6 - 8 at % | vorzugsweise 7 at % |
| B | z = 3 - 9 at % | |
| Cu | w = 0 - 1,5 at %. | |

Legierungen dieses Systems sind wegen ihrer linearen Schleifenform und des sehr guten Frequenzverhaltens sowohl für ISDN- als auch für POTS-Tiefpaßfilter gut geeignet.

Legierungssystem 6:

Ein sechstes für Tiefpaßfilter in Frequenzweichen geeignetes Legierungssystem hat die Zusammensetzung $(Fe_{0,98}Co_{0,02})_{90-x}Zr_7B_{2+x}Cu_1$ mit x= 0-3,vorzugsweise x = 0, wobei bei entsprechendem Abgleich der restlichen Legierungsbestandteile Co durch Ni ersetzbar ist.

Legierungen dieses Systems sind wegen ihrer linearen Schleifenform und des sehr guten Frequenzverhaltens sowohl für ISDN- als auch für POTS-Tiefpaßfilter gut geeignet.

Die Legierungssysteme 3 bis 6 erhalten nach der Wärmebehandlung eine feinkristalline Struktur mit Korndurchmessern unter 100 nm. Diese Körner sind von einer amorphen Phase umgeben, die allerdings weniger als 50 % des Materialvolumens einnimmt.

Legierungssystem 7:

Ferner können POTS-Tiefpaßfilter aus Metallbandkerne aus kristallinen gewalzten Bändern hergestellt werden. Zur Erzielung der notwendigen Frequenzeigenschaften der Permeabilität muß die Banddicke unter 50 µm, vorzugsweise unter 30 µm liegen. Als funktionsfähiges Legierungssystem wurde gefunden:

$$Ni_xFe_yM_z$$

wobei M eines oder mehrere Elemente aus der Gruppe Nb, Mo, Mn, Si, Al, Ti, Cr bezeichnet und x+y+z= 100 at% gilt, mit

| | | |
|---|---|---|
| Ni | x= 35-68 at% | vorzugsweise 50 - 65 at % |
| Fe | y = 100 at % - x - z | |
| M | z = 0 - 9 at % | vorzugsweise 0,5 - 3 at % |

Bei der Herstellung der Metallbandkerne kann neben einer Rekristallisationsglühung bei 800 - 1250 °C je nach Legierungszusammensetzung eine weitere Anlaßbehandlung im Bereich 450 - 650 °C notwendig werden. Zur Einhaltung der normgerechten Linearitätseigenschaften müssen beide Behandlungen in einem reduzierenden Schutzgas erfolgen. Die Einstellung der magnetischen Vorzugsrichtung zur Erzielung einer flachen linearen Hystereseschleife erfolgt je nach Ni-Gehalt entweder über eine Querfeldwärmebehandlung oder über Kaltverformung, z.B. durch einen zusätzlichen Walzschritt.

Abgesehen von den für POTS-Tiefpaßfilter einsetzbaren Legierungen der Gruppen 1 bis 6 sind zusätzliche Kennzeichen der vorzugsweise einzusetzenden Legierungssysteme 2 bis 6:

- extrem lineare Hystereseschleife bis mindestens H = 600 mA/cm besser höher.
- Betrag der Sättigungsmagnetostriktion $|\lambda_s|$< 2 ppm, vorzugsweise < 0,1 ppm nach der Wärmebehandlung. Bei den Kobalt-Basis-Amorphwerkstoffen kann die Sättigungsmagnetostriktion dadurch eingestellt werden, daß der Fe- und Mn-Gehalt entsprechend feinangepaßt wird. Bei den nanokristallinen Legierungen kann die Sättigungsinduktion über die Größe des feinkristallinen Korns eingestellt werden, was durch eine gezielte Abstimmung der Wärmebehandlung und des Metalloidgehaltes bewerkstelligt werden kann.
- Sättigungsinduktion von 0.7 T - 1.7 T, wobei die Sättigungsinduktion durch Wahl des Gehaltes an Ni, Co, M, Si, B und C feinabgestimmt werden kann.

Bei den oben angeführten Legierungssystemen schließen die Kleiner-/Größerzeichen die Grenzen mit ein; alle at%-Angaben sind als ungefähr zu betrachten.

Die oben genannten Anforderungen und Legierungsbereiche werden nach Durchführung der beschriebenen Wärmebehandlung insbesondere durch die in Tabelle 2 aufgeführten Legierungsbeispiele eingehalten und erfüllt.

Aufgrund ihrer Kombination aus einer besonders niedrigen, konstanten Permeabilität und einer Sättigungsinduktion von nahezu 1 Tesla besitzen die in Tabelle 2 aufgeführten Beispiele für amorphe Kobalt-Basis-Legierungen besonders hohe Anisotropiefeldstärken von fallweise mehr als 8 A/m. Die in Tabelle 2 ebenfalls aufgeführten fein- oder nanokristallinen Legierungen zeichnen sich dagegen durch besonders hohe Werte der Sättigungsinduktion aus, die bis zu 1,7 Tesla betragen können. Diese lassen vergleichsweise hohe Permeabilitätswerte zu, wodurch gegenüber Ferritübertragern erfindungsgemäß weitere Vorteile hinsichtlich Baugröße und Bewicklung entstehen.

Tab. 2

| Zusammensetzung der Legierung [at %] | Struktur | Sättig.- induktion [T] | Anisotropiefeldstärke $H_a$ [A/cm] | Sättigungsmagnetostriktion $\lambda_s$ | |
|---|---|---|---|---|---|
| | | | | as quenched | wärmebehandelt |
| $Co_{71.7}Fe_{1.1}Mo_1Mn_4Si_{13.2}B_9$ | amorph | 0,82 | 1,5 | $-12*10^{-8}$ | $-3,5*10^{-8}$ |
| $Co_{72.5}Fe_{1.5}Mo_{0.2}Mn_4Si_{4.8}B_{17}$ | amorph | 1,0 | 3,5 | $-12*10^{-8}$ | $-4,1*10^{-8}$ |
| $Co_{72.8}Fe_{4.7}Si_{5.5}B_{17}$ | amorph | 0,99 | 4,8 | $-32*10^{-8}$ | $-1,6*10^{-8}$ |
| $Co_{55.6}Fe_{6.1}Mn_{1.1}Si_{4.3}B_{16.2}Ni_{16.5}$ | amorph | 0,93 | 8,0 | $-110*10^{-8}$ | $+4,2*10^{-8}$ |
| $Fe_{73,5}Cu_1Nb_3Si_{15,5}B_7$ | nanokr. | 1,21 | 0,7 | $+24*10^{-6}$ | $+1,6*10^{-7}$ |
| $(Fe_{0,98}Co_{0,02})_{90}Zr_7B_2Cu_1$ | nanokr, | 1,70 | 1,7 | - | $-1,0*10^{-7}$ |
| $Fe_{84}Zr_{3,5}Nb_{3,5}B_8Cu_1$ | nanokr. | 1,53 | 0,8 | $+3*10^{-6}$ | $+1,5*10^{-7}$ |
| $Fe_{84}Nb_7B_9$ | nanokr. | 1,5 | 1,2 | - | $+1,0*10^{-7}$ |

**Patentansprüche**

1. Tiefpaßfilter für eine Frequenzweiche zur Trennung von niederfrequenten Signalen analoger Kommunikationssysteme von hochfrequenten Signalen digitaler Kommunikationssysteme mit einer Vielzahl von in Reihe geschalteten, mit Hilfe von Magnetkernen gebildeten Längsinduktivitäten (9),
**dadurch gekennzeichnet,**
**daß** die Magnetkerne derart aus einer amorphen oder nanokristallinen Legierung hergestellt sind, daß die Längsinduktivitäten (9) eine Sättigungsinduktion von $B_s > 0{,}6T$, ein Sättigungs- zu Remanenzverhältnis $B_r/B_s < 0{,}2$ und eine bis oberhalb von 10kHz weitestgehend konstante Permeabilität aufweisen.

2. Tiefpaßfilter nach Anspruch 1,
**dadurch gekennzeichnet,**
**daß** die Legierung die Zusammensetzung $Fe_aM_bSi_xB_yR_z$ aufweist,
wobei M ein oder mehrere Elemente aus der Gruppe Co, Ni bezeichnet und R ein oder mehrere Elemente aus der Gruppe C, V, Nb, Mn, Ti, Cr, Mo, W bezeichnen und

$$a+b+x+y+z = 100\ \%$$

ist, mit:

| | |
|---|---|
| Fe | a = 61 - 82 at % |
| Co / Ni | b = 0 - 20 at % |
| Si | x = 0,5 - 19 at % |
| B | y = 7 - 23 at % |
| R | z = 0 - 3 at % |

wobei 70 < a + b < 86 at% und 14 <x+y+z< 30 at% gilt.

3. Tiefpaßfilter nach Anspruch 2,
**dadurch gekennzeichnet,**
**daß** für a und b die Beziehung 73 < a + b < 85 at % gilt.

4. Tiefpaßfilter nach Anspruch 1,
**dadurch gekennzeichnet,**
**daß** die Legierung die Zusammensetzung

$$Co_a(Fe_{1-c}Mn_c)_bNi_dM_eSi_xB_yC_z,$$

aufweist, wobei M ein Element oder mehrere Elemente aus der Gruppe Nb, Mo, Ta, Cr, W, Ge und P bezeichnet und a+b+c+d+e+x+y+z = 100 ist, mit:

| | |
|---|---|
| Co | a = 40 - 82 at% |
| Mn/Fe | c = 0 - 1 |
| Fe+Mn | b = 3 - 10 at% |
| Ni | d = 0 - 30 at% |
| M | e = 0 - 5 at% |
| Si | x = 0 - 15 at% |
| B | y = 8 - 26 at% |
| C | z = 0 - 3 at% |

wobei 15<e+x+y+z<30 gilt.

5. Tiefpaßfilter nach Anspruch 4,
**dadurch gekennzeichnet,**

**daß** die folgenden Beziehungen gelten:

| | |
|---|---|
| Co | a = 50 - 82 at% |
| Mn/Fe | c = 0 - 0,5 |
| Fe+Mn | b = 3 - 10 at% |
| Ni | d = 0 - 20 at% |
| M | e = 0 - 3 at% |
| Si | x = 1 - 15 at% |
| B | y = 8 - 20 at% |
| C | z = 0 - 3 at% |

wobei 18<e+x+y+z<25 gilt.

**6.** Tiefpaßfilter nach Anspruch 1,
**dadurch gekennzeichnet,**
**daß** die Legierung die Zusammensetzung $Fe_xCu_yM_zSi_vB_w$ aufweist, wobei M ein Element oder mehrere Elemente aus der Gruppe Nb, W, Ta, Zr, Hf, Ti, Mo bezeichnet und x + y + z + v + w = 100 % ist, mit:

| | |
|---|---|
| Fe | x = 100 % - y - z - v - w |
| Cu | y = 0,5 - 2 at % |
| M | z = 1 - 5 at % |
| Si | v = 6,5 - 18 at % |
| B | w = 5 - 14 at % |

wobei v + w > 18 at % ist.

**7.** Tiefpaßfilter nach Anspruch 6,
**dadurch gekennzeichnet,**
**daß** folgenden Beziehungen gelten:

| | |
|---|---|
| Fe | x = 100 % - y - z - v - w |
| Cu | y = 1 at% |
| M | z = 2 - 3 at % |
| Si | v = 14 - 17 at % |
| B | w = 5 - 14 at % |

wobei v+w = 22 - 24 at % ist.

**8.** Tiefpaßfilter nach Anspruch 1,
**dadurch gekennzeichnet,**
die Legierung die Zusammensetzung $Fe_xZr_yNb_zB_vCu_w$ aufweist,
wobei x + y + z + v + w = 100 at % ist, mit:

| | |
|---|---|
| Fe | x = 100 at % - y - z - v - w |
| Zr | y = 2 - 5 at % |
| Nb | z = 2 - 5 at % |
| B | v = 5 - 9 at % |
| Cu | w = 0,5 - 1,5 at % |

wobei y + z > 5 at %
und y + z + v > 11 gilt.

**9.** Tiefpaßfilter nach Anspruch 8,
**dadurch gekennzeichnet,**

**daß** folgende Beziehungen gelten:

| | |
|---|---|
| Fe | x = 83 - 86 at % |
| Zr | y = 3 - 4 at % |
| Nb | z = 2 - 5 at % |
| B | v = 5 - 9 at % |
| Cu | w = 1 at % |

wobei x+z > 7 at %, und y + z + v = 12 - 16 at % gilt.

**10.** Tiefpaßfilter nach Anspruch 1,
**dadurch gekennzeichnet,**
**daß** die Legierung die Zusammensetzung $Fe_xM_yB_zCu_w$ aufweist,
wobei M ein Element aus der Gruppe Zr, Hf, Nb bezeichnet und x + y + z + w = 100 at % ist, mit:

| | |
|---|---|
| Fe | x = 100 at%-y-z-w |
| M | y = 6 - 8 at % |
| B | z = 3 - 9 at % |
| Cu | w = 0 - 1,5 at %. |

**11.** Tiefpaßfilter nach Anspruch 10,
**dadurch gekennzeichnet,**
**daß** die folgenden Beziehungen gelten:

| | |
|---|---|
| Fe | x = 83 - 90 at % |
| M | y = 7 at % |
| B | z = 3 - 9 at % |
| Cu | w = 0 - 1,5 at %. |

**12.** Tiefpaßfilter nach Anspruch 1,
**dadurch gekennzeichnet,**
**daß** die Legierungen die Zusammensetzung $(Fe_{0,98}Co_{0,02})_{90-x}Zr_7B_{2+x}Cu_1$ aufweisen mit x = 0-3, wobei bei entsprechendem Abgleich der restlichen Legierungsbestandteile Co durch Ni ersetzbar ist.

**13.** Tiefpaßfilter nach Anspruch 12,
**dadurch gekennzeichnet,**
**daß** x = 0 gilt.

**14.** Tiefpaßfilter nach Anspruch 1,
**dadurch gekennzeichnet,**
**daß** die Legierung die Zusammensetzung $Ni_xFe_yM_z$ aufweist, wobei M eines oder mehrere Elemente aus der Gruppe Nb, Mo, Mn, Si, Al, Ti, Cr bezeichnet und x+y+z= 100at% gilt, mit

| | |
|---|---|
| Ni | x = 35-68 at% |
| Fe | y = 100 at % - x - z |
| M | z = 0 - 9 at % |

**15.** Tiefpaßfilter nach Anspruch 14,
**dadurch gekennzeichnet,**
**daß** x = 50 - 65 at % und z = 0,5 - 3 at % gilt.

## Claims

**1.** Low-pass filter for a diplexer for separating low-frequency signals of analogue communication systems from high-frequency signals of digital communication systems, comprising a plurality of series inductors (9) formed with the aid of magnetic cores, **characterised in that** the magnetic cores are produced from an amorphous or nanocrystalline alloy in such a manner that the series inductors (9) display saturation induction of $B_s > 0.6$ T, a saturation to remanence ratio of $B_r/B_s < 0.2$ and substantially constant permeability to more than 10 kHz.

**2.** Low-pass filter according to claim 1, **characterised in that** the alloy has the composition $Fe_aM_bSi_xB_yR_z$, where M represents one or more elements from the group Co and Ni and R represents one or more elements from the group C, V, Nb, Mn, Ti, Cr, Mo and W and a + b + x + y + z = 100 %, with:

| | |
|---|---|
| Fe | a = 61 - 82 at % |
| Co/Ni | b = 0 - 20 at % |
| Si | x = 0.5 - 19 at % |
| B | y = 7 - 23 at % |
| R | z = 0 - 3 at %, |

where 70 < a + b < 86 at % and 14 < x + y + z < 30 at %.

**3.** Low-pass filter according to claim 2, **characterised in that** the relation 73 < a + b < 85 at % holds for a and b.

**4.** Low-pass filter according to claim 1, **characterised in that** the alloy has the composition $Co_a(Fe_{1-c}Mn_c)_bNi_dM_eSi_xB_yC_z$, where M represents one or more elements from the group Nb, Mo, Ta, Cr, W, Ge and P and

$$a + b + c + d + e + x + y + z = 100,$$

with:

| | |
|---|---|
| Co | a = 40 - 82 at % |
| Mn/Fe | c = 0 - 1 |
| Fe + Mn | b = 3 - 10 at % |
| Ni | d = 0 - 30 at % |
| M | e = 0 - 5 at % |
| Si | x = 0 -15 at % |
| B | y = 8 - 26 at % |
| C | z = 0 - 3 at %, |

where 15 < e + x + y + z < 30.

**5.** Low-pass filter according to claim 4, **characterised in that** the following relations hold:

| | |
|---|---|
| Co | a = 50 - 82 at % |
| Mn/Fe | c = 0 - 0.5 |
| Fe+Mn | b = 3 -10 at % |
| Ni | d = 0 - 20 at % |
| M | e = 0 - 3 at % |
| Si | x = 1 -15 at % |
| B | y = 8 - 20 at % |
| C | z = 0 - 3 at %, |

where 18 < e + x + y + z < 25.

**6.** Low-pass filter according to claim 1, **characterised in that** the alloy has the composition $Fe_xCu_yM_zSi_vB_w$, where M represents one or more elements from the group Nb, W, Ta, Zr, Hf, Ti and Mo and x + y + z + v + w = 100 %, with:

| Fe | x = 100% - y - z - v - w |
|---|---|
| Cu | y = 0.5 - 2 at % |
| M | z = 1 - 5 at % |
| Si | v = 6.5 - 18 at % |
| B | w = 5 -14 at %, |

where v + w > 18 at %.

7. Low-pass filter according to claim 6, **characterised in that** the following relations hold:

| Fe | x = 100 % - y - z - v - w |
|---|---|
| Cu | y = 1 at % |
| M | z = 2 - 3 at % |
| Si | v = 14 -17 at % |
| B | w = 5 -14 at %, |

where v + w = 22 - 24 at %.

8. Low-pass filter according to claim 1, **characterised in that** the alloy has the composition $Fe_xZr_yNb_zB_vCu_w$, where x + y + z + v + w = 100 at %, with:

| Fe | x = 100 at % - y - z - v - w |
|---|---|
| Zr | y = 2 - 5 at % |
| Nb | z = 2 - 5 at % |
| B | v = 5 - 9 at % |
| Cu | w = 0.5 - 1.5 at %, |

where y + z > 5 at %
and y + z + v > 11.

9. Low-pass filter according to claim 8, **characterised in that** the following relations hold:

| Fe | x = 83 - 86 at % |
|---|---|
| Zr | y = 3 - 4 at % |
| Nb | z = 2 - 5 at % |
| B | v = 5 - 9 at % |
| Cu | w = 1 at %, |

where x + z > 7 at %, and y + z + v = 12 - 16 at %.

10. Low-pass filter according to claim 1, **characterised in that** the alloy has the composition $Fe_xM_yB_zCu_w$, where M represents an element from the group Zr, Hf and Nb and x + y + z + w = 100 at %, with:

| Fe | x = 100 at % - y - z - w |
|---|---|
| M | y = 6 - 8 at % |
| B | z = 3 - 9 at % |
| Cu | w = 0 - 1.5 at %. |

11. Low-pass filter according to claim 10, **characterised in that** the following relations hold:

| Fe | x = 83 - 90 at % |
|---|---|
| M | y = 7 at % |
| B | z = 3 - 9 at % |

(continued)

| Cu | w = 0 - 1.5 at %. |
|---|---|

**12.** Low-pass filter according to claim 1, **characterised in that** the alloys have the composition $(Fe_{0.98}Co_{0.02})_{90-x}Zr_7B_{2+x}Cu_1$, with x = 0 - 3, where Co can be replaced by Ni, with corresponding adjustment of the remaining alloying constituents.

**13.** Low-pass filter according to claim 12, **characterised in that** x = 0.

**14.** Low-pass filter according to claim 1, **characterised in that** the alloy has the composition $Ni_xFeyM_z$, where M represents one or more elements from the group Nb, Mo, Mn, Si, Al, Ti and Cr and x + y + z = 100 at %, with

| Ni | x = 35 - 68 at % |
|---|---|
| Fe | y = 100 at % - x - z |
| M | z = 0 - 9 at %. |

**15.** Low-pass filter according to claim 14, **characterised in that** x = 50 - 65 at % and z = 0.5 - 3 at %.

**Revendications**

**1.** Filtre passe-bas pour un diplexeur pour séparer des signaux basses fréquences dans des systèmes de communication analogiques par rapport à des signaux de haute fréquence de systèmes de communication numérique comportant un grand nombre d'inductances longitudinales (9), branchées en série, et constituées par des noyaux magnétiques,
**caractérisé en ce que**
les noyaux magnétiques sont réalisés en un alliage amorphe ou nanocristallin,
les inductances longitudinales (9) ont une inductance de saturation $B_s$ > 0,6T, un rapport saturation/rémanence $B_r/B_s$ < 0,2 et une perméabilité très largement constante au-dessus de 10 kHz.

**2.** Filtre passe-bas selon la revendication 1,
**caractérisé en ce que**
l'alliage a la composition suivante :

$$Fe_aM_bSi_xB_yR_z,$$

dans laquelle M représente un ou plusieurs éléments du groupe Co, Ni, et R représente un ou plusieurs éléments des groupes C, V, Nb, Mn, Ti, Cr, Mo, W, et
a+b+x+y+z = 100 % :

| Fe | a = 61 - 82 % at |
|---|---|
| Co/Ni | b = 0 - 20 % at |
| Si | x = 0,5 - 19 % at |
| B | y = 7 - 23 % at |
| R | z = 0 - 3 % at |

dans ces relations 70 < a + b < 86 % at et
14 <x+y+z< 30 % at.

**3.** Filtre passe-bas selon la revendication 2,
**caractérisé en ce que**
a et b sont liés par la relation suivante :

$73 < a + b < 85$ % at.

**4.** Filtre passe-bas selon la revendication 1, **caractérisé en ce que** l'alliage a la composition suivante :

$$Co_a\,(Fe_{1-c}Mn_c)_bNi_dM_eSi_xB_yC_z,$$

dans laquelle M est un ou plusieurs éléments du groupe Nb, Mo, Ta, Cr, W, Ge, P et a+b+c+d+e+x+y+z = 100 ; avec:

| | |
|---|---|
| Co | a = 40 - 82 % at |
| Mn/Fe | c = 0 - 1 |
| Fe+Mn | b = 3 - 10 % at |
| Ni | d = 0 - 30 % at |
| M | e = 0 - 5 % at |
| Si | x = 0 - 15 % at |
| B | y = 8 - 26 % at |
| C | z = 0 - 3 % at |

avec $15<e+x+y+z<30$.

**5.** Filtre passe-bas selon la revendication 4, **caractérisé par** les relations suivantes :

| | |
|---|---|
| Co | a = 50 - 82 % at |
| Mn/Fe | c = 0 - 0,5 |
| Fe+Mn | b = 3 - 10 % at |
| Ni | d = 0 - 20 % at |
| M | e = 0 - 3 % at |
| Si | x = 1 - 15 % at |
| B | y = 8 - 20 % at |
| C | z = 0 - 3 % at |

avec $18<e+x+y+z<25$.

**6.** Filtre passe-bas selon la revendication 1, **caractérisé en ce que** l'alliage a pour composition $Fe_xCu_yM_zSi_vB_w$ dans laquelle M est un ou plusieurs éléments du groupe Nb, W, Ta, Zr, Hf, Ti, Mo et x + y + z + v + w = 100 % avec:

| | |
|---|---|
| Fe | x = 100 % - y - z - v - w |
| Cu | y = 0.5 - 2 % at |
| M | z = 1 - 5 % at |
| Si | v = 6, 5 - 18 % at |
| B | w = 5 - 14 % at |

avec v + w > 18 % at.

**7.** Filtre passe-bas selon la revendication 6, **caractérisé par** les relations suivantes :

| Fe | x= 100 % - y - z - v - w |
|---|---|
| Cu | y = 1 % at |
| M | z = 2 - 3 % at |
| Si | v = 14 - 17 % at |
| B | w = 5 - 14 % at |

avec v+w = 22 - 24 % at.

**8.** Filtre passe-bas selon la revendication 1, **caractérisé en ce que** l'alliage a pour composition $Fe_xZr_yNb_zB_vCu_w$ avec x + Y + z + v + w = 100 % at et

| Fe | x= 100 % - y - z - v - w |
|---|---|
| Zr | y = 2 - 5 % at |
| Nb | z = 2 - 5 % at |
| B | v = 5 - 9 % at |
| Cu | w = 0,5-1,5 % at |

avec y + z > 5 % at
et y + z + v > 11.

**9.** Filtre passe-bas selon la revendication 8, **caractérisé par** les relations suivantes :

| Fe | x = 83 - 86 % at |
|---|---|
| Zr | y = 3 - 4 % at |
| Nb | z = 2 - 5 % at |
| B | v = 5 - 9 % at |
| Cu | w = 1 % at |

avec x+z > 7 % at et y + z + v = 12 - 16 % at.

**10.** Filtre passe-bas selon la revendication 1, **caractérisé en ce que** l'alliage a pour composition $Fe_xM_yB_zCu_w$, M étant un élément du groupe Zr, Hf, Nb et x + y + z + w = 100 % at avec

| Fe | x = 100 % at-y-z-w-86 % at |
|---|---|
| M | y = 6 - 8 % at |
| B | z = 3 - 9 % at |
| Cu | w = 0 - 1,5 % at |

**11.** Filtre passe-bas selon la revendication 10, **caractérisé par** les relations suivantes :

| Fe | x = 83 - 90 % at |
|---|---|
| M | y = 7 % at |
| B | z = 3 - 9 % at |
| Cu | w = 0 - 1,5 % at. |

**12.** Filtre passe-bas selon la revendication 1, **caractérisé en ce que** l'alliage a pour composition $(Fe_{0,98}Co_{0,02})_{90-x}Zr_7B_{2+x}Cu_1$ avec x = 0-3 et pour la même formulation des composants résiduels de l'alliage, Co peut être remplacé par Ni.

**13.** Filtre passe-bas selon la revendication 12,
**caractérisé en ce que**
x=0.

**14.** Filtre passe-bas selon la revendication 1,
**caractérisé en ce que**
l'alliage a pour composition $Ni_xFe_yM_z$ et M est un ou plusieurs éléments du groupe Nb, Mo, Mn, Si, Al, Ti, Cr et x+y+z= 100 % at avec

| | |
|---|---|
| Ni | x = 35-68 % at |
| Fe | y = 100 % at - x - z |
| M | z = 0 - 9 % at. |

**15.** Filtre passe-bas selon la revendication 14,
**caractérisé en ce qu'**
on a x = 50 - 65 % at et z = 0,5 - 3 % at.

FIG 1
ADSL
5
ISDN
POTS
6
1
4
3
4
2
5
ADSL
ISDN
POTS
6

FIG 2
3
7
8
10
10
10
10
9
9
9
POTS/ISDN
10
10

FIG 3
1.2
0.8
0.4
0
-0.4
-0.8
-1.2
B [T]
-15
-10
-5
0
5
10
15
H [A /cm ]

FIG 4
100000
10000
1000
100
μ
$Fe_{73,5}Cu_1Nb_3Si_{15,5}B_7$
$(Fe_{0,98}Co_{0,02})_{90}Zr_7B_2Cu_1$
$(CoFe)_{72,8}(MoMnSiB)_{27,2}$
$(CoFe)_{74}(MoMnSiB)_{26}$
$(CoFe)_{77,5}(SiB)_{22,5}$
$(CoFeNi)_{78,5}(MnSiB)_{21,5}$
0
2
4
6
8
10
12
14
$H_{dc}$ [A/cm]

FIG 5
100000
10000
1000
100
10
1
μs', μs''
0.001
0.01
0.1
1
10
100
1000
100000
f [MHz]
11
12
13
14
fg
fg
μs'
μs''

FIG 6
100000
10000
1000
100
10
|Z| [Ω]
0.001
0.01
0.1
1
10
100
1000
10000
f [MHz]
16
15
fg
fg

FIG 7

μs''
70000
60000
50000
40000
30000
20000
10000
0
0.01
0.1
1
10
100
1000
f [kHz]
theoretisch
H=0.2mA/cm
H=1mA/cm
H=2mA/cm
H=3mA/cm
H=5mA/cm
H=7mA/cm
H=12mA/cm
H=15mA/cm
H=17mA/cm
H=20mA/cm
H=30mA/cm